# EUROPÄISCHE PATENTANMELDUNG

(11) **EP 1 154 375 A1**
(43) Veröffentlichungstag der Anmeldung: **14.11.2001**
(21) Anmeldenummer: 00109978.7
(22) Anmeldetag: 11.05.2000
(51) Int. Cl.: G06K 19/073, G06F 1/00, G11C 5/00

(54) **Schaltungsanordnung zur Detektion einer äusseren Einwirkung auf einen Halbleiterchip**

(71) Anmelder: Infineon Technologies AG, 81669 München (DE)
(72) Erfinder: Taddiken, Hans, 81737 München (DE); Dietl, Joseph, 81373 München (DE); Gail, Markus, 81547 München (DE); Brandstaeter, Helmut, 8010 Graz (AT)
(74) Vertreter: Fischer, Volker, Dipl.-Ing.

(57) **Zusammenfassung**

Die Erfindung schlägt eine monolithisch integrierte Schaltungsanordnung in einem Halbleiterchip zur Detektion einer äußeren Einwirkung auf den Halbleiterchip vor, bei der ein Signaleingang (1) der Schaltungsanordnung mit einem ersten Eingang (6) eines Vergleichmittels (5) verbunden ist und bei der der Signaleingang mit dem Knotenpunkt aus einem zweiten Eingang (7) des Vergleichmittels und einem von der äußeren Einwirkung Spannungsabhängigen Element (3) verbunden ist. Der Ausgang (8) des Vergleichmittels (5) ist mit einer Schutzvorrichtung für weitere Schaltungsanordnungen des Halbleiterchips verbunden.

## Beschreibung

Die Erfindung betrifft eine monolithisch integrierte Schaltungsanordnung in einem Halbleiterchip zur Detektion einer äußeren Einwirkung auf den Halbleiterchip.

Halbleiterchips, die insbesondere in Chipkarten oder Geldkarten zum Einsatz kommen, unterliegen besonderen Sicherheitsanforderungen. Das Vermeiden eines unbefugten Zugriffes durch Dritte auf Speicherinhalte oder die Funktionsweise eines derartigen Halbleiterchips, spielt bei der Entwicklung eine entscheidende Rolle. Unbefugte können sich beispielsweise dadurch Kenntnis über das System und über die gespeicherten, sicherheitsrelevanten Daten verschaffen, indem sie Fehler im Ablauf des Rechenwerkes erzeugen und somit versuchen, aus den resultierenden Ergebnissen Kenntnisse zu erhalten. Die Fehler können beispielsweise durch das Einstrahlen von Licht oder α-Strahlung erzeugt werden. Hierdurch werden die Diffusionsleckströme vergrößert, wodurch ein Teil der Signale unter Umständen nicht mehr während eines Taktes auf den bestimmungsgemäßen Wert anzusteigen vermag. Hierdurch errechnet ein Gatter einen falschen Wert. Je häufiger ein derartiges Verrechnen erzwungen wird, desto größer ist die statistische Wahrscheinlichkeit, daß Kenntnisse über das System erlangt werden.

Es gibt verschiedene Lösungsvorschläge, einen mittels Lichteinstrahlung durchgeführten "Angriff" auf einen Halbleiterchip zu unterbinden. So ist beispielsweise in der EP 0 178 512 A1 eine Schaltungsanordnung beschrieben, deren Speicher vor einer elektrooptischen Analyse geschützt ist. Das dort beschriebene Prinzip beruht darauf, daß beim Einsatz von Strahlung zumindest ein Teil der Speicherzellen ausgangsseitig auf ein definiertes Potential, unabhängig vom Ladungszustand der Speicherzellen, geschaltet wird und damit die gespeicherte Information nicht erkennbar ist. Möglich wird dieses Vorgehen dadurch, daß im Umfeld der Speicherzellen ein oder mehrere strahlungsempfindliche Sensoren integriert sind, deren Ausgangssignal vorzugsweise zur definierten Festlegung der an den Speicherausgängen anliegenden Spannung benützt wird.

Weiterhin ist aus der US 5,053,992 ein Halbleiterchip bekannt, der einen geheime Daten beinhaltenden Speicher aufweist, ein undurchsichtiges Gehäuse und eine Vorrichtung zum Löschen der geheimen Daten in dem Fall, in dem das Gehäuse vom Halbleiterchip entfernt wird. Die Vorrichtung zum Löschen der Daten beinhaltet dabei ein lichtsensitives Element mit einer bei Lichteinfall detektierbaren Stromcharakteristik. Ein Schaltmittel ist mit dem Speicher verbunden, wobei bei einer Belichtung des lichtsensitiven Elementes die Stromänderung erfasst wird und die geheimen Daten aus dem Speicher entfernt werden. Als lichtsensitive Elemente werden hierbei Dioden und Bipolartransistoren vorgeschlagen, bei denen unter Lichteinwirkung ein Rückwärtsstrom detektierbar ist.

Die aus dem Stand der Technik bekannten Anordnungen weisen jedoch den Nachteil auf, daß sie lediglich eine elektrooptische Analyse verhindern. Die oben angesprochene α-Strahlung, die die gleichen Wirkungen wie Licht hervorruft, kann mittels der im Stand der Technik beschriebenen Anordnungen nicht detektiert werden.

Die Aufgabe der vorliegenden Erfindung besteht deshalb darin, eine integrierte Schaltung anzugeben, bei der Fehler im Rechenwerk durch eine äußere Einwirkung vermieden werden können.

Diese Aufgabe wird mit den Merkmalen des Patentanspruches 1 gelöst. Die Erfindung schlägt somit eine monolithisch integrierte Schaltungsanordnung in einem Halbleiterchip zur Detektion einer äußeren Einwirkung auf den Halbleiterchip vor, bei der ein Signaleingang der Schaltungsanordnung mit einem ersten Eingang eines Vergleichsmittels verbunden ist und bei der der Signaleingang ferner mit dem Knotenpunkt aus einem zweiten Eingang eines Vergleichsmittels und einem von der äußeren Einwirkung spannungsabhängigen Element verbunden ist und bei der der Ausgang des Vergleichsmittels mit einer Schutzvorrichtung für weitere Schaltungsanordnungen des Halbleiterchips verbunden ist.

Mit der Erfindung wird das Erreichen einer Spannung auf einen "High-Wert" innerhalb einer festgelegten Zeitspanne überprüft, wobei bei einer Unterschreitung des erwarteten Wertes durch die Schaltungsanordnung ein Alarmprogramm ausgelöst wird. Dieses kann beispielsweise im Auslösen eines Resets der weiteren Schaltungsanordnung oder dem Löschen von relevanten Daten bestehen. Die Erfindung detektiert somit mittels des Vergleichsmittels den Signalhub, indem einer der Eingänge des Vergleichsmittels mit einem von der äußeren Einwirkung spannungsabhängigen Element verbunden wird. Je größer die äußere Einwirkung ist, desto geringer wird der Signalhub. Liegt am Signaleingang ein getaktetes Signal an, welches beispielsweise das Clock-Signal des Halbleiterchips sein kann, so wird das spannungsabhängige Element derart dimensioniert, daß es innerhalb eines Taktes unter der äußeren Einwirkung den erwarteten High-Wert nicht erreichen kann.

Anstatt die Ursache der äußeren Einwirkung zu detektieren, sieht die Erfindung die Detektion der Wirkung vor. Mit der erfindungsgemäßen Schaltungsanordnung wird somit überprüft, ob der Halbleiterchip bestimmungsgemäß funktioniert, daß heißt rechnet. Die Erfindung ist somit unabhängig vom Mechanismus der Störung. Es kann somit sowohl eine elektrooptische Analyse als auch eine Analyse mittels α-Strahlung unterbunden werden. Hierbei wird die Verwendung eines Lichtsensors vermieden. Die Erfindung bietet somit einen unauffälligen Schutz gegen einen unbefugten Zugriff auf einen Halbleiterchip.

Vorteilhafte Ausgestaltungen ergeben sich aus den Unteransprüchen.

Vorteilhafterweise ist mit dem ersten Eingang des Vergleichsmittels ein von der äußeren Einwirkung spannungsunabhängiges Element verbunden. Hierdurch wird der Spannungs-Referenzwert für das Vergleichsmittel festgelegt.

In einer bevorzugten Ausgestaltung ist das von der äußeren Einwirkung abhängige Element ein erster Ladungsspeicher, der unter der äußeren Einwirkung einen Diffusionsleckpfad aufweist. Dies kann beispielsweise ein Ladungsspeicher sein, der mit einem pn-Übergang verbunden ist. Je stärker die äußere Einwirkung ist, desto mehr Strom fließt über den Diffusionsleckpfad des pn-Überganges. Hierdurch verringert sich der Endwert, auf den der Ladungsspeicher aufgeladen werden kann.

Das von der äußeren Einwirkung unabhängige Element ist vorteilhafterweise ein Ladungsspeicher, der keinen oder höchstens einen im Vergleich zu dem ersten Ladungsspeicher nur geringen Diffusionsleckpfad aufweist. Dies kann beispielsweise ein Kondensator sein, dessen Platten aus Polysilizium bestehen, wobei sich ein Dielektrikum dazwischen befindet. Hierdurch wird das am Signaleingang anliegende getaktete Signal auch unter einer äußeren Einwirkung unverfälscht an den ersten Eingang des Vergleichsmittels weitergegeben. Es versteht sich von selbst, daß die Frequenz des getakteten Signales mit der Größe des Ladungsspeichers abgestimmt sein muß, so daß innerhalb eines Taktes eine vollständige Aufladung des Ladungsspeichers erfolgen kann.

Als Vergleichsmittel wird vorteilhafterweise ein XOR-Gatter vorgesehen. Es ist denkbar, daß der Signaleingang ein von einer der weiteren Schaltungsanordnungen des Halbleiterchips erzeugtes Signal empfängt. Es ist jedoch auch denkbar, daß ein eigener Taktgenerator für die erfindungsgemäße Schaltungsanordnung vorgesehen wird.

Die Erfindung wird anhand der nachfolgenden Figuren weiter erläutert. Es zeigen:
- Figur 1: Den prinzipiellen Aufbau der erfindungsgemäßen Schaltungsanordnung und
- Figur 2: die an verschiedenen Stellen der Schaltungsanordnung abgegriffenen Signale.

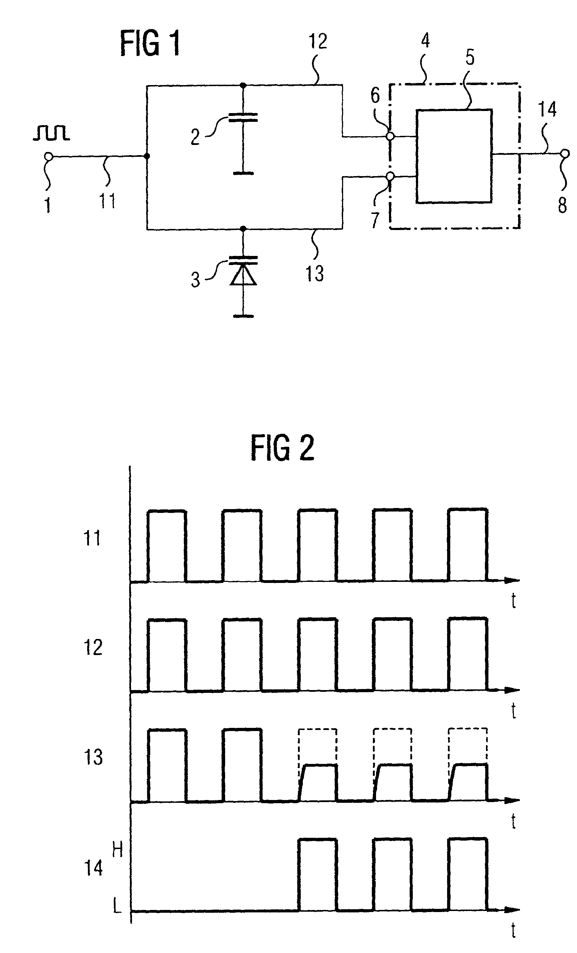

Figur 1 zeigt eine prinzipielle Schaltungsanordnung zur Detektion einer äußeren Einwirkung auf einen Halbleiterchip. An einem Signaleingang 1 liegt ein getaktetes Signal an. Der Signaleingang 1 ist einerseits mit einem ersten Eingang 6 eines Vergleichsmittels 4 und andererseits mit dem Knotenpunkt zwischen einem zweiten Eingang 7 des Vergleichsmittels 4 und einem unter einer äußeren Einwirkung spannungsabhängigen Element 3 verbunden. Das spannungsabhängige Element 3 ist als mit einem Bezugspotential verbundener Kondensator ausgeführt, der in integrierter Form auf dem Halbleiterchip ausgeführt ist. Der Kondensator 3 ist dabei entweder durch einen pn-Übergang gebildet oder aber ist als Poly-Poly-Kapazität ausgeführt, wobei eine Elektrode mit einem pn-Übergang verbunden ist. Die Kapazität 3 weist die Eigenschaft auf, daß diese unter der äußeren Einwirkung einen sehr hohen Diffusionsleckstrom aufweist. Hierdurch verringert sich der Endwert, auf den der Kondensator aufgeladen werden kann. Mit dem ersten Eingang 6 des Vergleichsmittels 4 ist ebenfalls ein Kondensator verbunden, der mit seinem anderen Anschluß mit dem Bezugpotential verbunden ist. Im Gegensatz zu dem Kondensator 3 weist der Kondensator 2 unter der äußeren Einwirkung keinen Diffusionsleckstrom auf. Der Kondensator 2 kann beispielsweise eine Metallkapazität oder eine Poly-Poly-Kapazität sein.

Als Vergleichsmittel 4 kann beispielsweise ein XOR-Gatter 5 vorgesehen sein, das mit seinem Ausgang 8 mit einer weiteren (nicht dargestellten) Schaltungsanordnung verbunden ist, wodurch beim Ermitteln eines unterschiedlichen Signalhubs, bedingt durch die äußere Einwirkung, ein Reset oder Löschen der Daten der weiteren Schaltungsanordnung ermöglicht wird. Die Kapazitäten 2, 3 sind derart dimensioniert, daß sie während eines Taktes des Eingangsignales auf- und entladen werden. Durch die Verknüpfung mit dem XOR-Gatter wird am Ausgang 8 ohne äußere Einwirkung grundsätzlich ein Low-Signal erzeugt. Eine Erhöhung des Diffusionsleckstromes der Kapazität 3 verhindert ein Aufladen während des Taktes, so daß am Ausgang des XOR-Gatters 5 ein High-Signal erzeugt wird. Hierdurch wird das Alarmprogramm in der weiteren Schaltungsanordnung ausgelöst.

Die Erfindung beruht somit auf dem Prinzip unterschiedlicher Signalhübe in den Pfaden des spannungsabhängigen und des spannungsunabhängigen Elementes. Diese durch äußere Einflüsse bedingten Änderungen der Signalhübe werden detektiert. Zur Realisierung des spannungsabhängigen Elementes können bereits vorhandene parasitäre Elemente der weiteren Schaltungsanordnung benutzt werden. Auf die Verwendung eines lichtsensitiven Elementes, zum Beispiel einer speziellen Fotochiode oder eines Fototransistors kann hingegen verzichtet werden.

In der Figur 2 werden die Signalverläufe an unterschiedlichen Stellen der in Figur 1 dargestellten Schaltungsanordnung mit als auch ohne äußere Einwirkung näher erläutert. Mit 11 ist das in Signaleingang 1 anliegende getaktete Eingangssignal bezeichnet. Die Ziffer 12 bezeichnet das am den ersten Eingang 6 des Vergleichsmittels 4 anliegende Spannungssignal. In diesem Pfad ist das von der äußeren Einwirkung unabhängige Element 2 vorgesehen, so daß der Signalverlauf im wesentlichen dem Eingangssignal 11 entspricht. Das an dem zweiten Eingang 7 des Vergleichsmittels 4 anliegende Signal 13 verläuft ohne äußere Einwirkung dergestalt, daß sich die Kapazität 3 innerhalb eines Taktes vollständig auf- und wieder entladen kann. Sobald eine äußere Einwirkung vorhanden ist, vergrößert sich der Diffusionsleckstrom in der Kapazität 3, so daß an dem zweiten Eingang 7 des Vergleichsmittels 4 innerhalb eines Taktes der vorherbestimmte Spannungswert nicht erreicht werden kann. Durch die Verknüpfung der Signale 12 und 13 über ein XOR-Gatter wird bei gleichen Eingangssignalen ein Low-Wert (ohne äußere Einwirkung) generiert, während bei einer äußeren Einwirkung bei einem anliegenden High-Wert am Signaleingang 1 ein High-Wert erzeugt wird. Dieser sorgt für das Auslösen des Alarmprogrammes.

### Bezugszeichenliste

- 1: Signaleingang
- 2: Ladungsspeicher
- 3: Ladungsspeicher
- 4: Vergleichsmittel
- 5: XOR-Gatter
- 6: erster Eingang
- 7: zweiter Eingang
- 8: Ausgang
- 11: Eingangssignal
- 12: Einwirkungsunabhängiges Signal
- 13: Einwirkungsabhängiges Signal
- 14: Ausgangssignal

## Patentansprüche

1. Monolithisch integrierte Schaltungsanordnung in einem Halbleiterchip zur Detektion einer äußeren Einwirkung auf den Halbleiterchip,
**dadurch gekennzeichnet, daß**
- ein Signaleingang (1) der Schaltungsanordnung mit einem ersten Eingang (6) eines Vergleichsmittels (4) und mit dem Knotenpunkt aus einem zweiten Eingang (7) des Vergleichsmittels (4) und einem von der äußeren Einwirkung spannungsabhängigen Element (3) verbunden ist,
- der Ausgang (8) des Vergleichsmittels (4) mit einer Schutzvorrichtung für weitere Schaltungsanordnungen des Halbleiterchips verbunden ist.

2. Schaltungsanordnung nach Anspruch 1,
**dadurch gekennzeichnet, daß**
mit dem ersten Eingang (6) des Vergleichsmittels (4) ein von der äußeren Einwirkung spannungsunabhängiges Element (2) verbunden ist.

3. Schaltungsanordnung nach Anspruch 1 oder 2,
**dadurch gekennzeichnet, daß**
das von der äußeren Einwirkung abhängige Element (3) ein erster Ladungsspeicher ist, der unter der äußeren Einwirkung einen Diffusionsleckpfad aufweist.

4. Schaltungsanordnung nach einem der Ansprüche 1 bis 3,
**dadurch gekennzeichnet, daß**
das von der äußeren Einwirkung unabhängige Element (2) ein Ladungsspeicher ist, der keinen oder höchstens einen im Vergleich zu dem ersten Ladungsspeicher (3) nur geringen Diffusionsleckpfad aufweist.

5. Schaltungsanordnung nach einem der vorhergehenden Ansprüche,
**dadurch gekennzeichnet, daß**
als Vergleichsmittel ein XOR-Gatter vorgesehen ist.

6. Schaltungsanordnung nach einem der vorhergehenden Ansprüche,
**dadurch gekennzeichnet, daß**
an dem Signaleingang (1) ein getaktetes Signal anliegt.

7. Schaltungsanordnung nach einem der vorhergehenden Ansprüche,
**dadurch gekennzeichnet, daß**
der Signaleingang (1) ein von einer der weiteren Schaltungsanordnungen des Halbleiterchips erzeugtes Signal empfängt.
